(19)

Europäisches
Patentamt
European
Patent Office
Office européen
des brevets

(11) **EP 4 261 617 A1**

(12) **EUROPEAN PATENT APPLICATION**

(43) Date of publication:
**18.10.2023 Bulletin 2023/42**

(21) Application number: **22168304.8**

(22) Date of filing: **14.04.2022**

(51) International Patent Classification (IPC):
**G03F 7/20** $^{(2006.01)}$   **G06N 20/00** $^{(2019.01)}$

(52) Cooperative Patent Classification (CPC):
**G03F 7/706841; G06N 20/00**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BOTTEGAL, Giulio**
  **5500 AH Veldhoven (NL)**

• **CAO, Xingang**
  **5500 AH Veldhoven (NL)**
• **GARCIA FLOREZ, Francisco**
  **5500 AH Veldhoven (NL)**
• **VU, Tran, Thanh, Thuy**
  **5500 AH Veldhoven (NL)**
• **TSANG, Ka Wa**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHODS OF METROLOGY AND ASSOCIATED DEVICES**

(57) Disclosed is a method of updating of a first model by training a second model, the first model relating to a first process range and trained using a first set of measurement signals relating to a first set of structures. The method comprises: obtaining a second set of measurement signals, the second set of measurement signals relating to a second set of structures comprising said first set of structures or a subset thereof; and training the second model using said second set of measurement signals and corresponding reference values for the parameter of interest as training data. The training comprises optimizing a cost function in terms of the second model while constraining the second model to infer values for the parameter of interest from the first set of measurement signals .

Fig. 5

## Description

### BACKGROUND

Field of the Invention

0001 The present invention relates to methods of metrology performed to maintain performance in the manufacture of devices by patterning processes such as lithography. The invention further relates to methods of manufacturing devices using lithographic techniques. The invention yet further relates to computer program products for use in implementing such methods.

Related Art

0002 A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. A particularly important parameter of interest is overlay, which should, in general, be controlled to be within a few tens of nanometers in today's sub-micron semiconductor devices, down to a few nanometers in the most critical layers.

0003 Models may be used to infer a parameter of interest from measurement signals measured using a metrology device. Such models may be data-driven and trained on measured data with associated reference values. However, lithographic processes have a tendency to drift, and therefore these models may need periodic retraining.

0004 It would be desirable to improve retraining of such models.

### SUMMARY OF THE INVENTION

0005 According to a first aspect of the present invention there is provided a method of training or configuring a second model to infer a parameter of interest from one or more measurement signals, the second model comprising an update of a first model, the first model relating to a first process range and having been trained using a first set of measurement signals relating to a first set of structures having been exposed in a first time period; the method comprising: obtaining a second set of measurement signals, the second set of measurement signals relating to a second set of structures comprising said first set of structures or a subset thereof and additional structures exposed by the same process and/or on the same apparatus as the first set of structures in a second time period different to said first time period; and training or configuring the second model using said second set of measurement signals and corresponding reference values for the parameter of interest as training data such that the second model relates to a second process range of which said first process range is a sub-range; wherein the training comprises optimizing a cost function in terms of the second model while constraining the second model to infer values for the parameter of interest from a first set of measurement signals from the first set of structures which do not differ by more than a threshold margin from values for the parameter of interest inferred from said first set of measurement signals using said first model.

0006 According to a second aspect of the present invention there is provided a computer program product containing one or more sequences of machine-readable instructions for implementing calculating steps in a method according to the first aspect of the invention as set forth above 0007 The invention yet further provides a processing arrangement and metrology device comprising the computer program of the second aspect.

0008 These and other aspects and advantages of the apparatus and methods disclosed herein will be appreciated from a consideration of the following description and drawings of exemplary embodiments.

### BRIEF DESCRIPTION OF THE DRAWINGS

0009 Embodiments of the invention will now be described, by way of example only, with reference to the accompanying schematic drawings in which corresponding reference symbols indicate corresponding parts, and in which:

Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice;
Figures 4(a) and 4(b) are plots illustrating the issue of lack of backward consistency resulting from present extension model training methods; and
Figure 5 is a flowchart describing a method of training a model according to an embodiment.

### DETAILED DESCRIPTION OF EXEMPLARY EMBODIMENTS

0010 Before describing embodiments of the invention in detail, it is instructive to present an example environment in which embodiments of the present invention may be implemented.

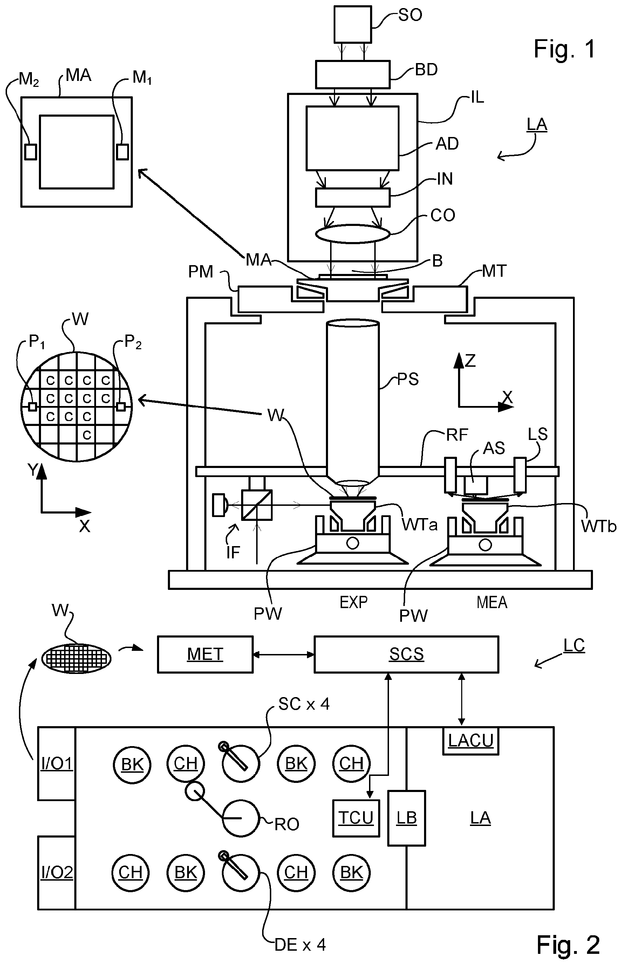

0011 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0012 The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

0013 The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

0014 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0015 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0016 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0017 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0018 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0019 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0020 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

0021 Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers, is described further below.

0022 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-) magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0023 Combinations and/or variations on the above described modes of use or entirely different modes of use may also be employed.

0024 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0025 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0026 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

0027 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0028 The metrology step with metrology system MET can also be done after the resist pattern has been etched into a product layer. The latter possibility limits the possibilities for rework of faulty substrates but may provide additional information about the performance of the manufacturing process as a whole.

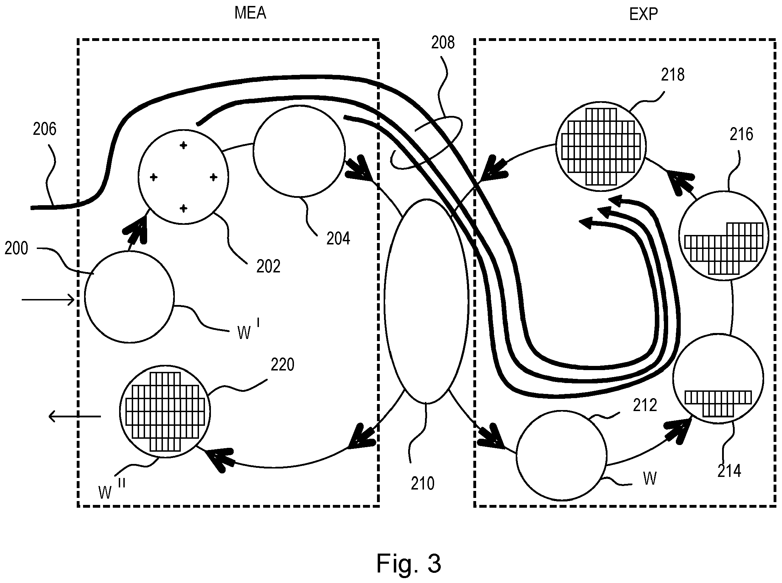

0029 Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

0030 On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

0031 Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

0032 The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

0033 At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

0034 At step 204, a map of wafer height (Z) against X-Y position is measured also using the level sensor LS. Primarily, the height map is used only to achieve accurate focusing of the exposed pattern. It may be used for other purposes in addition.

0035 When substrate W' was loaded, recipe data 206 were received, defining the exposures to be performed, and also properties of the wafer and the patterns previously made and to be made upon it. Where there is a choice of alignment marks on the substrate, and where there is a choice of settings of an alignment sensor, these choices are defined in an alignment recipe among the recipe data 206. The alignment recipe therefore defines how positions of alignment marks are to be measured, as well as which marks.

0036 At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

0037 By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

0038 A metrology method presently used comprises in-die metrology (IDM). This may be based on measurement of in-die targets on a spatial scale similar to the actual product structures for which they act as proxy (in fact, IDM metrology may be performed directly on the product structure if it is sufficiently regularized, and the term "target" used herein may refer to actual product structure when being used for metrology). The in-die targets are designed to be representative (e.g., to mimic) the exposure behavior, or more generally, the full patterning behavior of the product structure which they represent.

0039 The in-die targets may be measured using any suitable angle-resolved metrology apparatus to obtain a measurement signal or measurement pupil. A measurement pupil may comprise an "image" or acquisition of the pupil plane, i.e., an angle resolved spectrum or Fourier representation of the scattered radiation from the in-die target.

0040 A model can be trained to map the measurement pupils to a value for a parameter of interest (e.g., overlay). The concepts disclosed herein may be applied to the training of such a model. However, IDM is only one context for which the concepts disclosed herein are applicable; these concepts are more generally applicable to any metrology method which uses a trained model (e.g., a data-driven model, whether physics based or machine learning model).

0041 To train the model, self-referencing targets or reference targets may be provided on a reticle which also comprises the in-die targets. These in-die and reference targets can then be exposed, processed (e.g., etched etc.) on a wafer and measured. These reference targets may, for example, be located at the periphery of the field (e.g., in a scribe lane). The reference targets typically comprise a target array comprising multiple targets with different biases. The biases may average (or sum to) zero over the array such that a measurement averaged over the array should represent the on-product overlay. Measurement signals acquired on each reference target are labeled with the overlay bias (across the exposed layers) for training purposes. These training label biases/overlay values are known with good accuracy, since reticle writing error is small. The model then learns to associate a specific reference target measurement signal with its respective reference target overlay bias value or label.

0042 The training may be repeated for different acquisition settings (e.g., wavelengths/polarizations etc. of the measurement radiation) and/or other settings varied and/or for different training wafers, e.g., to allow for processing variations between nominally identical targets. The output of such training may comprise multiple, e.g., in the order of hundreds (for example between 100 and 500), candidate measurement recipes, wherein a measurement recipe may be a combination of a trained model and an acquisition setting. For example, during training the acquisition setting may be a free parameter such that each acquisition setting has a corresponding model, such that a measurement recipe comprises the combination of these. There will be different weight matrices within the model for each recipe.

0043 The in-die targets may be formed without any intentional overlay bias and therefore have no explicit label (i.e. they are labeled zero). A matching step is then performed to determine a matching metric or matching indicator (matching KPI) which quantifies how well matched the in-die target response is to the self-reference target response. This matching is typically performed by inferring an overlay value from the reference targets using a candidate metrology recipe and comparing this to an inferred overlay value from an in-die target using the same candidate metrology recipe. The closer the inferred values are, the better matched the measurement recipe is (e.g., the matching KPI may be based on the difference between the values). More specifically, present methods may compare an average of the inferred overlay values from the reference target array (over which the biases will average/sum to zero) and an overlay value inferred from a single in-die target (for example the in-die target nearest the reference cluster).

0044 The above-described IDM metrology method is one example of a data-driven metrology approach in which a mathematical model is trained and used to translate acquired measurement signals into a parameter of interest. More generally, these models are typically trained in a training procedure in which an algorithm learns a function $f$ that satisfies the relation $p = f(S)$, where $p$ is the parameter of interest and S is the signal acquired using the metrology system (e.g., a measurement pupil or representation thereof in the IDM example). This function is typically learned by solving a regression problem, which may, for example, take the form:

$$\min_{f} \sum_{i=1}^{\#targets} \left( p_{set,i} - f(S_i) \right)^2 + R(f),$$

where $p_{set,i}$ is a reference (set) value of the parameter of interest at a given location $i$ of a wafer, $S_i$ is the corresponding acquired metrology signal, and $R(f)$ is an optional regularization term which helps obtain more accurate estimates of $f$.

0045 The targets from which the reference values of the parameter of interest are taken may be comprised on a series of training wafers. These wafers may be Design of Experiment (DoE) wafers, where the parameter of interest is purposely perturbed or varied to induce a better excitation of the metrology signal, or Process of Reference (PoR) wafers, where special targets with known parameter of interest values are printed on dedicated areas of the wafer (e.g. the scribe lane) to allow for frequent training and monitoring. An example of the latter type of targets are the aforementioned self-reference targets described above in relation to IDM training.

0046 Independently of the type of wafers being used to learn the function, the inference model may over time become less accurate or unable to correctly infer the parameter of interest, due to drifts or changes in the initial manufacturing process window or first process range. In such a case, a further training may be performed, sometimes referred to as "recipe extend", to train a new model that can correctly infer the parameter of interest under an extended process window or second process range (i.e., such that the first process range is a sub-range of the second process range). This new model is typically trained using some of or all of the wafers that were used in the previous model training, plus one or more new wafers to teach the model how to behave under the drifted process window.

0047 An undesired effect of this procedure is that, given a signal S acquired by the metrology tool on a certain target of a certain wafer, a parameter of interest value inferred using a model created with recipe extend will generally be different from a parameter of interest value inferred using a model created in the initial model training, even when that target is within the process window of and/or used to train both models. In other words:

$$f_0(S) \neq f_1(S),$$

where $f_0$ is the first or initial model learned in the initial model training and $f_1$ is the second model learned via recipe extend.

0048 As a consequence, if a target on a wafer that has been measured prior to recipe extend is measured a second time, it will have two apparently acceptable values for the parameter of interest associated with it, one for each model $f_0$, $f_1$. This is because both models $f_0$, $f_1$ are expected to be good models for the wafers used in the initial training, as these wafers are within the process window applicable to both models. This can compromise the perceived validity of the recipe extend procedure. In particular, this backward consistency issue can have detrimental consequences in Advanced Process Correction (APC) control strategies, where large changes in the reported Parameter of interest (in this case, overlay), can compromise the effectiveness of the Correction per Exposure (CPE) process. Briefly, APC is a control strategy which identifies correctable variation in a performance parameter such as overlay, and defines and applies a set of corrections to a lot (batch) of wafers to correct this variation. In determining these corrections, corrections from previous lots are taken into account in order to avoid overcorrecting the noise in the measurements.

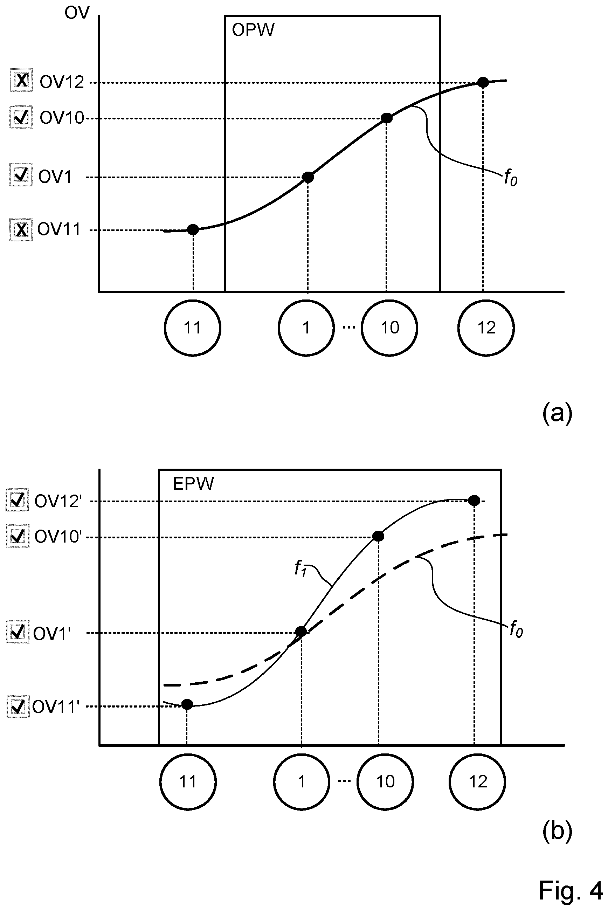

0049 A visual example of the backward consistency issue is depicted in Figure 4. Figure 4(a) comprises a plot of a first model or inference function $f_0$, which has been trained only on wafers 1 to 10, and not wafers 11 and 12. As such, the inference function $f_0$ covers a certain original process window OPW. Overlay OV (or other parameter of interest) of wafers 1 to 10 within the process window OPW (e.g., OV1 and OV10 from wafers 1 and 10) are reported correctly; however the reported overlay outside of this process window (e.g., OV11 and OV12 from wafers 11 and 12) is not valid.

0050 Figure 4(b), shows a plot of a second (extended) model function $f_1$, having a corresponding extended process window EPW which has been extended by including wafers 11 and 12 in the training of this model. As such, the overlay values OV11', OV12' obtained using this second model are valid. The reported overlay OV1' and OV10' using second model $f_1$ on signals from wafers within the original process window OPW are also valid (i.e., remaining within acceptable accuracy limits), however they may be significantly different to overlay values OV1 and OV10 determined using original function $f_0$.

0051 To address this issue, a model or recipe extension training strategy is proposed which ensures backward consistency with respect to a previously trained inference model, of the reported parameter of interest from previously measured wafers.

0052 Such a method may comprise applying a constraint on the extension training (second model training) which constrains the second model to infer values for the parameter of interest from a first set of measurement signals from a first set of targets or structures comprising targets (on wafers) used to train the original trained model such that these inferred values do not differ by more than an acceptable or threshold margin defined by a consistency parameter, with inferred values using the original trained model (first model) on said first set of measurement signals.

0053 The proposed method may comprise retraining the model using a second set of targets, the second set of targets comprising the first set of targets used to train the original model $f_0$, or a subset thereof, and additional targets from an additional one or more wafers related to the a drifted process window or second process range. The additional targets may be exposed at a later time after training of the first model, during which there has been a drift in the process range with respect to a first process range relating to the training of the first model, the process ranges relating to a process used to expose the targets. The training may comprise solving the following optimization problem:

$$\min_{f_1} \sum_{i=1}^{T_1} \left( p_{set,i} - f_1(S_i) \right)^2 + R(f)$$

$$\text{s.t. } \frac{1}{T_0} \sum_{i=1}^{T_0} \left( f_1(S_i) - f_0(S_i) \right)^2 \leq \epsilon^2$$

where $f_0(S)$ denotes a certain trained inference function or model (first model) and $f_1(S)$ denotes the process window extended version of this model (second model). $T_1$ denotes the total number of targets in the second set of targets as measured in the extended training pool (e.g., in the example of Figure 4: wafers 1 to 12), and $T_0$ denotes the number of targets in the first set of targets measured in the first model training (e.g., in the example of Figure 4: wafers 1 to 10).

0054 As can be seen, this optimization problem comprises an additional constraint that imposes the newly trained function $f_1$ to provide, on the initial training target set, values of the parameter of interest close to those provided by $f_0$. More specifically, the difference (in this specific embodiment the mean-squared difference, although other difference metrics or error metrics may be used) in the reported parameter of interest between the models is constrained to be not larger than a consistency parameter $\epsilon^2$. Such a consistency parameter may be user-defined and may be chosen or tuned based on a desired level of backward consistency.

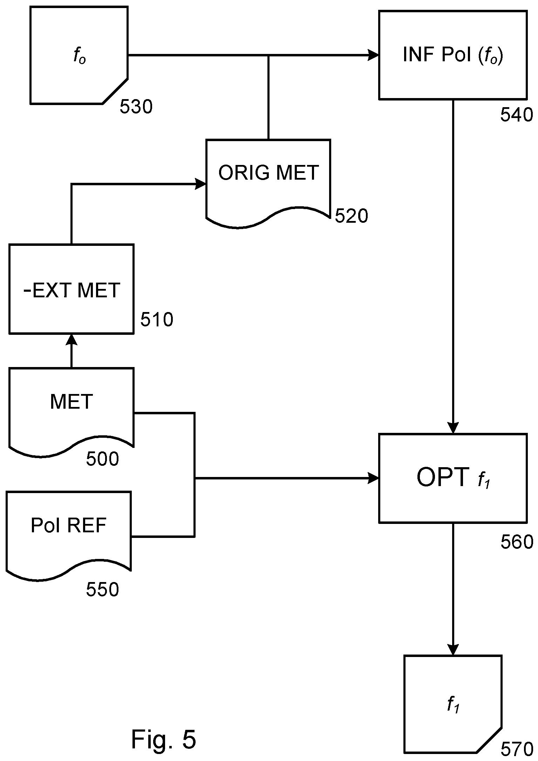

0055 Figure 5 is a flowchart describing a method for embodying the above disclosed concepts. The proposed method can be fully integrated in existing software programs.

0056 Metrology data comprising metrology signals 500 is acquired. These metrology signals may be measured from targets on training wafers which include some or all of the initial wafers used to initially train first model $f_0$ and targets from at least one additional wafer. At step 510, the metrology signals relating to the additional or extension wafers are removed from metrology signals 500 to leave only the metrology signals 520 acquired on the initial wafers. The originally trained inference function $f_0$ 530 is used to infer values 540 for the parameter of interest from the metrology signals 520 acquired on only the initial wafers.

0057 The metrology signals 500 and corresponding known reference values 550 for the parameter of interest are used in an optimization 560 to determine the second model $f_1$ 570, the optimization being constrained such that reported parameter of interest values using the second model $f_1$ 570 on the metrology signals 520 do not differ too much (e.g., as defined by a consistency parameter) from the inferred parameter of interest values at step 540.

0058 The parameter of interest may comprise, for example: overlay, edge placement error or other placement metric, critical dimension, side wall angle difference of opposing side walls, bottom grating asymmetry, grating imbalance, (etch) tilt of layers of interest, or any other parameter related to performance of a lithographic process and/or yield.

0059 Further embodiments are disclosed in the subsequent list of numbered clauses:

1. A method of training or configuring a second model to infer a parameter of interest from one or more measurement signals, the second model comprising an update of a first model, the first model relating to a first process range and having been trained using a first set of measurement signals relating to a first set of structures having been exposed in a first time period; the method comprising:

obtaining a second set of measurement signals, the second set of measurement signals relating to a second set of structures comprising said first set of structures or a subset thereof and additional structures exposed by the same process and/or on the same apparatus as the first set of structures in a second time period different to said first time period; and
training or configuring the second model using said second set of measurement signals and corresponding reference values for the parameter of interest as training data such that the second model relates to a second process range of which said first process range is a sub-range; wherein the training comprises optimizing a cost function in terms of the second model while constraining the second model to infer values for the parameter of interest from a first set of measurement signals from the first set of structures which do not differ by more than a threshold margin from values for the parameter of interest inferred from said first set of measurement signals using said first model.

2. A method as defined in clause 1, wherein said threshold margin is defined by a consistency parameter.

3. A method as defined in clause 2, comprising selecting or tuning said consistency parameter to select or tune a consistency between the first model and second model.

4. A method as defined in any preceding clause, wherein the second time period is subsequent to said first time period.

5. A method as defined in any preceding clause, wherein said training comprises minimizing the cost function so as to minimizes a difference between an inferred value of the parameter of interest for each measurement signal of the second set of measurement signals using the second model and a respective reference value of the parameter of interest.

6. A method as defined in clause 5, wherein the difference minimized is a mean-squared difference.

7. A method as defined in any preceding clause, comprising the steps of:

separating said first set of measurement signals from the second set of measurement signals; and applying said first model to said first set of measurement signals to obtain said values for the parameter of interest inferred from said first set of measurement signals using said first model.

8. A method as defined in any preceding clause, wherein said first set of structures are comprised on one or more first calibration substrates and said second set of structures are comprised on said one or more first calibration substrates or a subset thereof and on one or more second calibration substrates.

9. A method as defined in any preceding clause, comprising an initial step of exposing the one or more second calibration substrates.

10. A method as defined in any preceding clause, wherein said parameter of interest comprises one of overlay, edge placement error or other placement metric, critical dimension, side-wall-angle difference of opposing side walls, bottom grating asymmetry, grating imbalance, tilt of one or more layers of interest.

11. A method as defined in any preceding clause, comprising measuring said second set of structures to obtain said second set of measurement signals.

12. A computer program comprising program instructions operable to perform the method of any preceding clause, when run on a suitable apparatus.

13. A non-transient computer program carrier comprising the computer program of clause 12.

14. A processing arrangement comprising:

a computer program carrier comprising the computer program of clause 13; and
a processor operable to run said computer program.

15. A metrology device comprising the processing arrangement of clause 14.

0060 Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

0061 The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams. 0062 The term "lens", where the context allows, may refer to any one or combination of various types of optical components, including refractive, reflective, magnetic, electromagnetic and electrostatic optical components.

0063 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0064 The breadth and scope of the present invention should not be limited by any of the above-described exemplary embodiments, but should be defined only in accordance with the following claims and their equivalents.

**Claims**

1. A method of training or configuring a second model to infer a parameter of interest from one or more measurement signals, the second model comprising an update of a first model, the first model relating to a first process range and having been trained using a first set of measurement signals relating to a first set of structures having been exposed in a first time period; the method comprising:

obtaining a second set of measurement signals, the second set of measurement signals relating to a second set of structures comprising said first set of structures or a subset thereof and additional structures exposed by the same process and/or on the same apparatus as the first set of structures in a second time period different to said first time period; and

training or configuring the second model using said second set of measurement signals and corresponding reference values for the parameter of interest as training data such that the second model relates to a second process range of which said first process range is a sub-range; wherein the training comprises optimizing a cost function in terms of the second model while constraining the second model to infer values for the parameter of interest from a first set of measurement signals from the first set of structures which do not differ by more than a threshold margin from values for the parameter of interest inferred from said first set of measurement signals using said first model.

2. A method as claimed in claim 1, wherein said threshold margin is defined by a consistency parameter.

3. A method as claimed in claim 2, comprising selecting or tuning said consistency parameter to select or tune a consistency between the first model and second model.

4. A method as claimed in any preceding claim, wherein the second time period is subsequent to said first time period.

5. A method as claimed in any preceding claim, wherein said training comprises minimizing the cost function so as to minimizes a difference between an inferred value of the parameter of interest for each measurement signal of the second set of measurement signals using the second model and a respective reference value of the parameter of interest.

6. A method as claimed in claim 5, wherein the difference minimized is a mean-squared difference.

7. A method as claimed in any preceding claim, comprising the steps of: separating said first set of measurement signals from the second set of measurement signals; and applying said first model to said first set of measurement signals to obtain said values for the parameter of interest inferred from said first set of measurement signals using said first model.

8. A method as claimed in any preceding claim, wherein said first set of structures are comprised on one or more first calibration substrates and said second set of structures are comprised on said one or more first calibration substrates or a subset thereof and on one or more second calibration substrates.

9. A method as claimed in any preceding claim, comprising an initial step of exposing the one or more second calibration substrates.

10. A method as claimed in any preceding claim, wherein said parameter of interest comprises one of overlay, edge placement error or other placement metric, critical dimension, side-wall-angle difference of opposing side walls, bottom grating asymmetry, grating imbalance, tilt of one or more layers of interest.

11. A method as claimed in any preceding claim, comprising measuring said second set of structures to obtain said second set of measurement signals.

12. A computer program comprising program instructions operable to perform the method of any preceding claim, when run on a suitable apparatus.

13. A non-transient computer program carrier comprising the computer program of claim 12.

14. A processing arrangement comprising:

a computer program carrier comprising the computer program of claim 13; and
a processor operable to run said computer program.

15. A metrology device comprising the processing arrangement of claim 14.

Fig. 1

Fig. 2

Fig. 3

(a)

(b)

Fig. 4

Fig. 5

Europäisches
Patentamt

European
Patent Office

Office européen
des brevets

# EUROPEAN SEARCH REPORT

Application Number

EP 22 16 8304

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/271172 A1 (LUO YA [US] ET AL) 2 September 2021 (2021-09-02) * abstract * * figure 5 * * paragraphs [0002], [0033], [0085] * | 1-15 | INV.<br>G03F7/20<br>G06N20/00 |
| A | US 2002/072003 A1 (BRILL BOAZ [IL] ET AL) 13 June 2002 (2002-06-13) * abstract * * figures 1,2 * * paragraphs [0001], [0055] - [0058], [0074] - [0078] * | 1-15 | |
| A | OPHIR BOAZ ET AL: "Machine learning for Tool Induced Shift (TIS) reduction: an HVM case study", SPIE SMART STRUCTURES AND MATERIALS + NONDESTRUCTIVE EVALUATION AND HEALTH MONITORING, 2005, SAN DIEGO, CALIFORNIA, UNITED STATES, SPIE, US, vol. 11611, 22 February 2021 (2021-02-22), pages 116110E-116110E, XP060140174, ISSN: 0277-786X, DOI: 10.1117/12.2590247 ISBN: 978-1-5106-4548-6 * the whole document * | 1-15 | TECHNICAL FIELDS SEARCHED (IPC)<br><br>G03F<br>G06N |
| A | KANG SEOKHO ET AL: "An intelligent virtual metrology system with adaptive update for semiconductor manufacturing", JOURNAL OF PROCESS CONTROL, OXFORD, GB, vol. 52, 20 February 2017 (2017-02-20), pages 66-74, XP029945519, ISSN: 0959-1524, DOI: 10.1016/J.JPROCONT.2017.02.002 * the whole document * | 1-15 | |

-/--

The present search report has been drawn up for all claims

| Place of search | Date of completion of the search | Examiner |
|---|---|---|
| Munich | 18 October 2022 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EUROPEAN SEARCH REPORT

**Application Number**

EP 22 16 8304

### DOCUMENTS CONSIDERED TO BE RELEVANT

| Category | Citation of document with indication, where appropriate, of relevant passages | Relevant to claim |
|---|---|---|
| A | US 2022/027784 A1 (YUAN ZHONG FANG [CN] ET AL) 27 January 2022 (2022-01-27)<br>* abstract *<br>* figure 1 *<br>* paragraphs [0001], [0017], [0032] *<br>----- | 1-15 |

**CLASSIFICATION OF THE APPLICATION (IPC)**

**TECHNICAL FIELDS SEARCHED (IPC)**

The present search report has been drawn up for all claims

| Place of search | Date of completion of the search | Examiner |
|---|---|---|
| Munich | 18 October 2022 | Andersen, Ole |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 4 261 617 A1**

## ANNEX TO THE EUROPEAN SEARCH REPORT
## ON EUROPEAN PATENT APPLICATION NO.

EP 22 16 8304

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2022

| Patent document cited in search report | | Publication date | Patent family member(s) | | Publication date |
|---|---|---|---|---|---|
| US 2021271172 | A1 | 02-09-2021 | JP | 6906058 B2 | 21-07-2021 |
| | | | JP | 2020510856 A | 09-04-2020 |
| | | | KR | 20190117724 A | 16-10-2019 |
| | | | KR | 20210118471 A | 30-09-2021 |
| | | | TW | 201837759 A | 16-10-2018 |
| | | | TW | 202123060 A | 16-06-2021 |
| | | | US | 2020026196 A1 | 23-01-2020 |
| | | | US | 2021271172 A1 | 02-09-2021 |
| | | | WO | 2018153866 A1 | 30-08-2018 |
| US 2002072003 | A1 | 13-06-2002 | AU | 1422502 A | 15-05-2002 |
| | | | DE | 60117286 T2 | 12-10-2006 |
| | | | EP | 1360554 A1 | 12-11-2003 |
| | | | IL | 139368 A | 10-12-2006 |
| | | | US | 2002072003 A1 | 13-06-2002 |
| | | | WO | 0237186 A1 | 10-05-2002 |
| US 2022027784 | A1 | 27-01-2022 | NONE | | |

EPO FORM P0459

For more details about this annex : see Official Journal of the European Patent Office, No. 12/82